# EUROPÄISCHE PATENTSCHRIFT

(11) **EP 1 239 544 B1**
(45) Veröffentlichungstag und Bekanntmachung des Hinweises auf die Patenterteilung: **22.11.2006**
(21) Anmeldenummer: 02003071.4
(22) Anmeldetag: 13.02.2002
(51) Int. Cl.: H01R 9/26

(54) **Elektrisches Gerät mit Busleiterabschnitt**
Electrical device with bus contact section
Appareil électrique avec section de contact à bus

(30) Priorität: 07.03.2001 DE 20103978 U
(43) Veröffentlichungstag der Anmeldung: 11.09.2002
(73) Patentinhaber: Weidmüller Interface GmbH & Co., 32760 Detmold (DE)
(72) Erfinder: Schnatwinkel, Michael, 32051 Herford (DE); Hanning, Walter, 32758 Detmold (DE)
(74) Vertreter: Specht, Peter

(56) Entgegenhaltungen:
- EP-A- 0 661 915
- WO-A-99/23737

## Beschreibung

Die Neuerung betrifft ein elektrisches Gerät mit modularem Aufbau zur Steuerung und/oder Überwachung technischer Prozesse und/oder zur Industrie- und/oder Gebäudeautomatisierung, das zur Weiterleitung von Busleitersignalen und/oder -versorgungspannungen einen internen Busleiterabschnitt aufweist, nach dem Oberbegriff des Anspruchs 1. Ein derartiges Gerät ist aus der EP 0661915 A1 bekannt.

Ein weiterer Busleiterabschnitt für ein elektrisches Gerät ist aus der EP 95 113 729 A2 bekannt. Bei dem in dieser Schrift gezeigten Gerät, bei dem der interne Busleiterabschnitt als durchgehende Platine mit darauf aufgebrachten Leiterbahnen ausgebildet ist, dienen auf Tragschienen anreihbare Anschlußblocks zur Signalanpassung zwischen einem übergeordneten Feldbus und an die Anschlußblocks angeschlossenen Initiatoren, Feldgeräten oder dergleichen. Die Anschlußblocks sind aus funktionsverschiedenen Anschluß- bzw. Modulscheiben zusammengesetzt, wobei zwischen Schutzleiterscheiben, Einspeisescheiben, Versorgungs-/Signalleiterscheiben und Rastfußscheiben unterschieden wird. Ein oder mehrere Anschlußblocks sind über den internen Busleiter mit einem Anschlußmodul für den Feldbus verbindbar.

Zum Stand der Technik sei noch die WO 99/83737 genannt.

Ein weiterer Busleiterabschnitt ist aus der EP 00 100 303 bekannt. Nach der Lehre dieser Schrift sind die Busleiterabschnitte der einzelnen Basis-Klemmenträger baulich voneinander getrennt ausgebildet und weisen jeweils eine Platine auf, die von wenigstens einer Reihe von Metallstiften durchsetzt ist, welche auf der einen Seite der Platine im wesentlichen senkrecht und auf der gegenüberliegenden Seite der Platine im wesentlichen parallel zur Platine ausgerichtet sind, wobei die wenigstens eine senkrecht zur Platine erstreckende Stiftreihe derart bemessen ist, daß ihre Stiftreihenenden direkt zum Kontaktieren einer Buchsenleiste nutzbar sind. Die bauliche Trennung der Busleiterabschnitte jeder Modulscheibe bringt zunächst den Vorteil einer nahezu beliebigen Reihbarkeit auch der Busleiterabschnitte mit sich und erhöht derart die Variabilität des gesamten Modulsystemes. Darüberhinaus bringt die gewählte bauliche Ausgestaltung des Busleiterabschnitts mit einer Platine und die Platine durchdringenden Winkelstiften besonderer Länge den Vorteil mit sich, daß separate Steckerelemente zum Kontaktieren eines separaten oder eines an eine Elektronik-Leiterplatte angeformten Gerätesteckers entfallen können.

Die Lösung der gattungsgemaßen EP 0661915 A1 hat sich an sich bewährt.

Es besteht jedoch der Wunsch nach einer Optimierung des elektrischen Gerätes und seines internen Busleiters für Einsatzfälle, in denen ein Bedarf an einer relativ hohen Anzahl von Daten- und/oder Versorgungsleitungen auf engstem Raum besteht. Die Lösung dieser Aufgabe ist ausgehend von der EP 0661915 A1 das Ziel der Erfindung.

Die Erfindung löst diese Aufgabe durch den Gegenstand des Anspruches 1.

Dadurch, daß nach Art einer T-Stück-(insbesondere Doppel-)verbindung mindestens zwei oder mehr Reihen bzw. eine den Erfordernissen angepaßte Anzahl von Anschlüssen quasi "aufeinandergereiht" bzw. "gestapelt" werden - und zwar vorzugsweise sowohl in Richtung der Elektronikleiterplatte als auch zwischen den Busleiterabschnitten benachbarter Module, ist auf einfachste Weise bei einfacher kundenspezifische Anpaßbarkeit (hohe Polzahl, Rangierbarkeit usw.) eine besonders hohe Pinanzahl auf engstem Raum realisierbar.

Damit wird diese Lösung mit der erfindungsgemäß angeordneten Platine (102) auch problematischsten Einsatzfällen mit einem Bedarf an einer Vielzahl von Busleiter-Datenleitungen gerecht. Ferner ist neben der Signal- und Versorgungsleitungsanordnung für die Elektronikleiterplatten auch eine Versorgung der Feldgeräte über den internen Busleiter realisierbar. Dabei kann auch eine Kompatibilität zur Modulbustechnik der EP 00 100 303 realisiert werden.

Es ist auch auf einfache Weise möglich, in mehreren Reihen von Anschlüssen verschiedene Arten von Anschlüssen wie Lichterleiteranschlüsse und metallische Leiteranschlüsse miteinander zu kombinieren. Auch auf der Leiterplatte ist in diesem Fall das Vorsehen einer Elektronik zur Lichtübertragung vorstellbar.

Die Mehrreihigkeit der Anschlüsse bietet auch die Möglichkeit zu einer problemlosen Variation der Kontaktgrößen. Durch unterschiedliche Kontaktgrößen ist der interne Busleiter auf diese Weise problemlos an verschiedene Stromtragfähigkeitserfordernisse anpaßbar. Die Lötanschlüsse können beliebig ausgebildet sein, so z.B. durchkontaktierend und/oder in SMD-Technik. Anstelle der Buchsen- und Stiftleisten zwischen den Nachbarmodulen sind auch Pfostenverbinder einsetzbar.

Weitere vorteilhafte Ausführungsformen der Neuerung sind den übrigen Unteransprüchen zu entnehmen. Nachfolgend wird die Neuerung unter Bezug auf die Zeichnung anhand von Ausführungsbeispielen näher beschrieben. Es zeigt:
- Fig. 1: eine perspektivische Ansicht einer Modulscheibe eines elektrischen Gerätes mit einem internen Busleiterabschnitt gemäß der Neuerung;
- Fig. 2a,b: zwei um 90° zueinander gedrehte Ansichten der Modulscheibe aus Fig. 1;

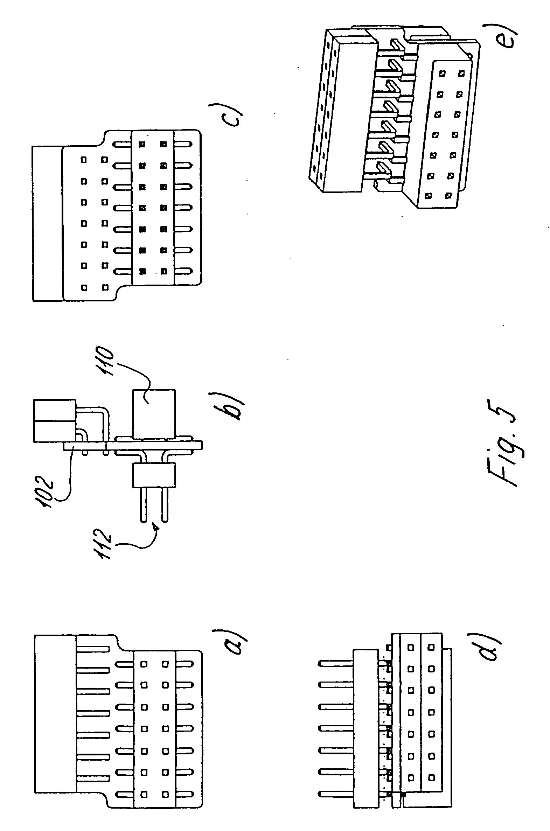

- Fig. 3 bis 5: verschiedene Ansichten interner Busleiterabschnitte; und

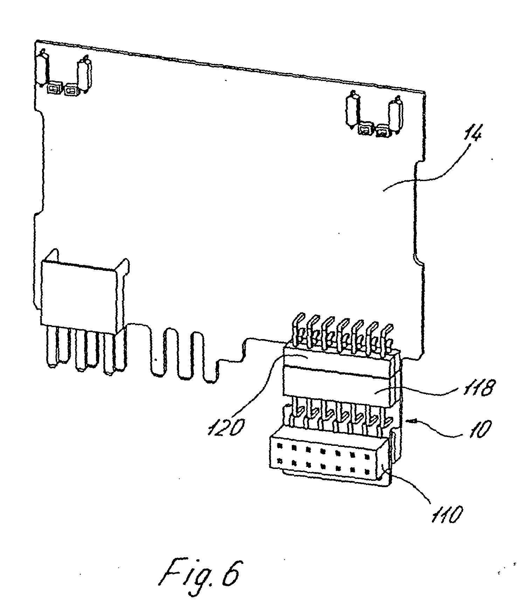

- Fig. 6: eine schematische Darstellung einer Elektronikleiterplatte nebst einem internen Busleiter.

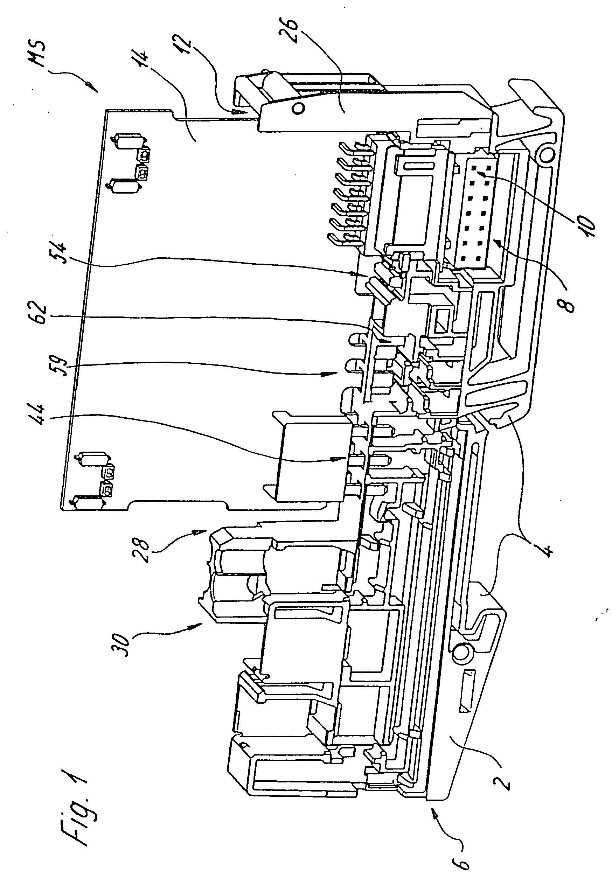

Fig. 1 zeigt eine Modulscheibe für ein hier ansonsten nicht dargestelltes Gerät der Automatisierungstechnik. Das Gerät umfaßt ein Gateway (hier nicht dargestellt), an welches u.a. die Modulscheiben anreihbar sind. Die Modulscheibe ist mit weiteren Modulscheiben zu einem Anschlußblock variabler Länge zusammenfügbar.

Die Modulscheibe weist nach Fig. 1 einen scheibenförmigen Basis-Klemmenträger 2 zur Verriegelung des Einzelmodules auf einer (hier nicht dargestellten) Tragschiene auf. Der Basis-Klemmenträger 2 ist hierzu mit Kunststoff-Rastfüßen 4 versehen, mit denen in an sich bekannter Weise die Rastverbindung zur Tragschiene herstellbar ist. Der Basis-Klemmenträger 2 umfaßt einen unteren Basisabschnitt 6, welcher sich in einen Bereich oberhalb der Tragschienenftiße 4 und neben den Tragschienenfüßen 4 beidseitig über die Tragschiene hinaus erstreckt. In dem Basisabschnitt 6 ist in dem einen von der Tragschiene abgewandt liegenden Außenbereich eine den Basis-Klemmenträger 2 senkrecht zu seiner Haupt-Erstreckungsebene durchdringende Ausnehmung bzw. Busleiteröffnung 8 zur Aufnahme des internen Busleiterabschnitts 10 vorgesehen, der eine Weiterleitung der Busleitersignale von Einzelmodul zu Einzelmodul und in die steckbare Elektronik-Leiterplatte 14 erlaubt, die senkrecht zur Tragschienenerstreckungsrichtung ausgerichtet ist.

Zur Aufnahme der Elektronik-Leiterplatte 14 ist in dem Bereich, welcher sich ungefähr von der Senkrechten zur Mitte der Tragschiene bis zu dem internen Busleiterabschnitt 10 erstreckt, in dem Basis-Klemmenträger 2 eine Umfangs-Ausnehmung 12 ausgebildet. Die Elektronik-Leiterplatte 14 ist mit einer (hier nicht dargestellten) Elektronikschaltung zur Verarbeitung/Weiterleitung der jeweils zur Elektronik-Leiterplatte 14 geführten Signale versehen.

Die Ausnehmung 12 wird an dem von der Tragschiene abgewandten Ende des Einzelmodules von einem senkrecht vom Basisabschnitt 6 abstehenden Steg 26 begrenzt, der an seiner zur Tragschiene 4 gewandten Seite mit einer Einschubnut 28 zum Einschieben eines nicht dargestellten Elektronikgehäuses versehen ist.

Ungefähr an dem dem Steg 26 gegenüberliegenden Ende des Basis-Klemmenträgers 2 ist an den Basisabschnitt 6 ein senkrecht nach oben vorstehender Anschlußabschnitt 30 angeformt.

Der Basis-Klemmenträger 2 bzw. die Modulscheibe umfaßt im Bereich der Umfangsaussparung 12 von dem Steg 26 aus gesehen nach innen zur Tragschiene hin u.a. folgende Funktionsbereiche:
- Busleiteröffnung BUS / 8
- Kennzeichnungskanal (für ein oder zwei Schilder) 54
- Potentialkontaktierungs-Öffnungen 59
- Steckerbuchsen/Anschlußöffnungen 44.

Eine Ausnehmung 62 ermöglicht das Einsetzen eines Kodierelementes.

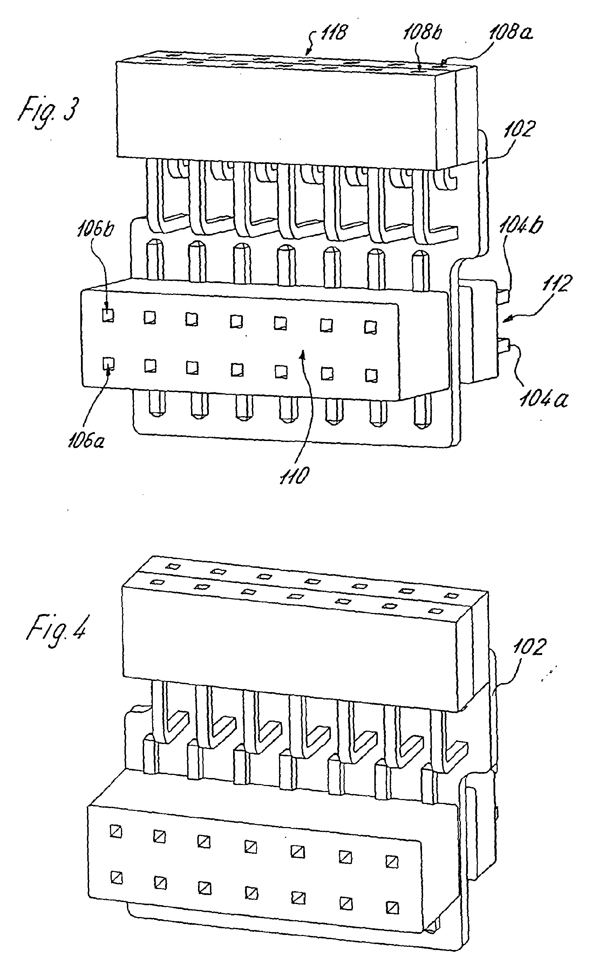

Der in die Öffnung 8 eingesetzte interne Busleiterabschnitt 10 jedes Basis-Klemmenträgers 2 weist jeweils eine Platine 102 (siehe auch Fig. 3) auf, senkrecht zu der zweimal zwei übereinander liegende Reihen von Anschlüssen 104a,b; 106a,b zur Weitergabe der Busleitersignale und/oder -versorgungsspannungen zwischen benachbarten Anschlußmodulen und parallel zu der hier beispielhaft zwei direkt übereinanderliegende Reihen von Anschlüssen 108a,b zur Weitergabe der Busleitersignale und/oder -versorgungsspannungen zwischen dem internen Busleiter und der Elektronikleiterplatte ausgebildet sind.

Die Platine 102 ist im wesentlichen parallel zur Elektronikleiterplatte des Anschlußmoduls ausgerichtet. Sie liegt im wesentlichen in der Ebene der Elektronikleiterplatte 14 in deren Haupterstreckungsebene und schließt sich direkt an die Elektronikleiterplatte 14 an.

Die Anschlüsse des internen Busleiters zu benachbarten Modulscheiben werden durch eine Doppelreihen-Steckerbuchsenleiste 110 und eine Doppelreihen-Steckerstiftleiste 112 gebildet, wobei bei nebeneinander liegenden Basis-Klemmenträgern 2 die Stekkerstiftleiste 112 in die Steckerbuchsenleiste 110 des Busleiterabschnittes 10 des jeweils benachbarten Basis-Klemmenträgers 2 eingreift. Anstelle von Buchsen- und Stiftleisten sind auch Pfostenverbinder realisierbar.

Diese Doppelreihenanordnung kann auch durch einen einzigen Pfostenverbinder realisiert werden, wenn kein Versatz von Signal und/oder Versorgungsleitungen benötigt wird.

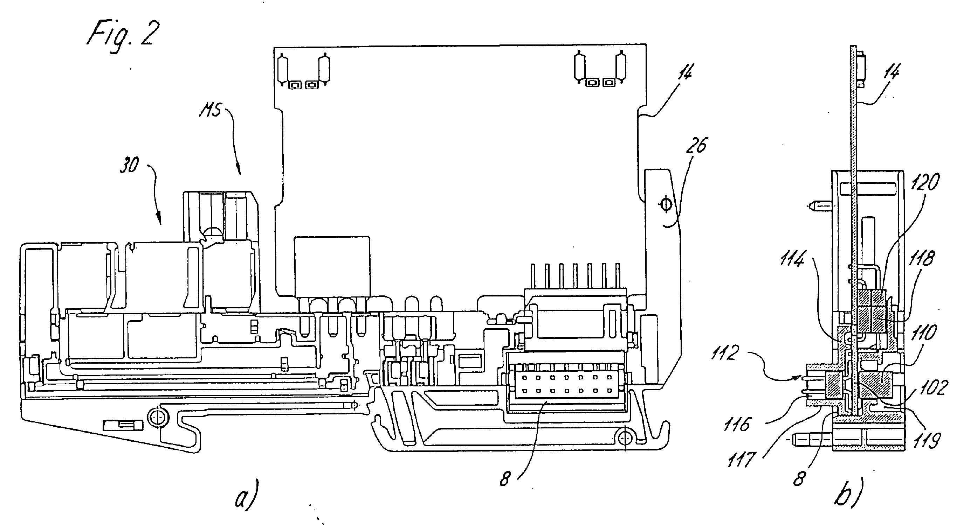

Wie ferner in Fig. 2b zu erkennen, ist die Platine 102 in die Öffnung 8 der Basis-Klemmenträger 2 einsetzbar, welche von einem Verschlußteil 114 verschließbar ist, welches seinerseits eine Öffnung 116 für die mindestens zwei übereinander liegenden Reihen von Anschlüssen zur Nachbarmodulscheibe und einen Führungsansatz 117 aufweist, der in eine entsprechende Ausnehmung 119 der Nachbarmodulscheibe eingreift.

Nach Art einer T-Stück-Verbindung ist hier zudem beispielhaft zur Realisierung der Anschlußreihen 108 a, b zur Elektronikleiterplatte 14 zusätzlich zu den Leisten 110, 112 eine doppelreihige Steckerbuchsenleiste 118 an der Platine 102 angeordnet, welche zur Kontaktierung einer ebenfalls doppelreihigen Steckerstiftleiste 120 an der Elektronikleiterplatte 14 dient. Diese Anordnung ist rein beispielhaft zu verstehen und auch umgekehrt realisierbar (Steckerstiftleiste an der Platine 102).

Werden nur sieben Kontakte zur Elektronikleiterplatte 14 benötigt, ist auch eine einreihige "Kontaktleiste" denkbar, was natürlich besonders kostengünstig ist.

Weiter kann alternativ auch jeweils eine Kontaktleiste auf beiden Seiten der Elektronikleiterplatte vorgesehen 14 sein.

Nach Art der Fig. 1ff sind zweimal sieben Anschlüsse 104, 106 und 108 vorgesehen, wobei die Anschlüsse 108 jeweils versetzt zwischen benachbarten Anschlüssen 104, 106 liegen (Rastversatz). Es werden also auf engem Raum 14 benachbarte Leitungen angeordnet, wobei je nach Anwendungsfall nicht alle dieser Leitungen genutzt und/oder zur Elektronikleiterplatte weitergegeben werden müssen.

Alternativ ist es auch denkbar, daß die Anschlüsse 108 zur Weitergabe der Busleitersignale und/oder -versorgungsspannungen zwischen dem internen Busleiter 10 und der Leiterplatte 102 nur Kontaktflächen als Leiterbahnen am Rand der Elektronikleiterplatte 14 darstellen und über einen Leiterplattenrandverbinder auf der Elektronikleiterplatte 14 verbunden werden.

Bei einer Kombination einer Modulscheibe mit einem Block wäre es denkbar, zumindest im Bereich der ersten Modulscheibe des Modulblockes eine Kontaktierung des internen Busleiters nach Art der ersten Modulscheibe und die weiteren Modulscheiben des Blockes über eine flach liegende Leiterplatte, z.B. nach Art der DE 44 38 801, zu verbinden (hier nicht dargestellt).

### Bezugszeichen

- Basis-Klemmenträger: 2
- Kunststoff-Rastfüße: 4
- Basisabschnitt: 6
- Busleiteröffnung/Ausnehmung: 8
- Busleiterabschnitt: 10
- Umfangs-Ausnehmung: 12
- Elektronik-Leiterplatte: 14
- Steg: 26
- Einschubnut: 28
- Anschlußabschnitt: 30
- Anschlußöffnungen: 44
- Kennzeichnungskanal: 54
- Potential-Kontaktierungsöffnung: 59
- Ausnehmung: 62
- Platine: 102
- Anschlüsse: 104a,b; 106a,b
- Anschlüsse: 108a,b
- Steckerbuchsenleiste: 110
- Steckerstiftleiste: 112
- Verschlußteil: 114
- Öffnung: 116
- Führungsansatz: 117
- Steckerbuchsenleiste: 118
- Ausnehmung: 119
- Steckerstiftleiste: 120

## Patentansprüche

1. Elektrisches Gerät mit modularem Aufbau zur Steuerung und/oder Überwachung technischer Prozesse und/oder zur Industrie- und/oder Gebäudeautomatisierung, das zur Weiterleitung von Busleitersignalen und/oder - versorgungspannungen einen internen Busleiterabschnitt aufweist,
a) mit wenigstens einem auf eine Tragschiene aufsetzbaren Anschlußmodul (MS) mit Anschlüssen für externe Leiter wobei jedes Anschlußmodul einen scheibenförmiger Basis-Klemmenträger (2) aufweist, der eine vorzugsweise steckbare Elektronikleiterplatte (14) aufweist, welche an einen internen Busleiter (10) anschließbar ist, wobei die Elektronikleiterplatte (14) im wesentlichen senkrecht zur Tragschiene ausgerichtet ist, wobei - wenn eine Mehrzahl von Anschlußklemmen vorgesehen ist - die Basis-Klemmenträger wie eine Reihung angeordnet sind,
b) wobei die internen Busleiterabschnitte (10) der einzelnen Basis-Klemmenträger (2) baulich voneinander getrennt ausgebildet sind und jeweils eine im Basis-Klemmenträger (2) angeordnete Platine (102) aufweisen, auf der mindestens zwei direkt übereinander liegende Reihen von Anschlüssen (104a,b; 106a,b) zur Weitergabe der Busleitersignale und/oder - versorgungsspannungen zwischen benachbarten Anschlußmodulen (M) und mindestens eine oder mehr - in diesem Fall direkt übereinanderliegende - Reihen von Anschlüssen (108a, b) zur Weitergabe der Busleitersignale und/oder -versorgungssparmungen zwischen dem internen Busleiter (10) und der Elektronikleiterplatte (14) vorgesehen sind,
**dadurch gekennzeichnet, dass**
c) die Platine (102) im wesentlichen parallel zur Elektronikleiterplatte (14) ausgerichtet ist.

2. Elektrisches Gerät nach Anspruch 1, **dadurch gekennzeichnet, daß** die Anschlüsse (14- 108) je nach Leiterzuführung eine T-Stückfunktionalität mit versetzten Leitern realisieren.

3. Elektrisches Gerät nach Anspruch 1 oder 2, **dadurch gekennzeichnet, daß** die Platine (102) im wesentlichen in der Ebene der Elektronikleiterplatte (14) im Anschlußmodul angeordnet ist und sich direkt an die Elektronikleiterplatte (14) anschließt.

4. Elektrisches Gerät nach einem der vorstehenden Ansprüche, **dadurch gekennzeichnet, daß** auf die Platine (102) mindestens zwei übereinander liegende Reihen von Steckerbuchsenleisten oder eine doppelreihige Steckerbuchsenleiste (110) und mindestens zwei direkt übereinander liegende Steckerstiftleisten oder eine doppelreihige Steckerstiftleiste (112) aufgesetzt sind, wobei bei nebeneinander liegenden Basis-Klemmenträgern (2) die Steckerstiftleiste(n) (112) in die Steckerbuchsenleiste(n) (110) des Busleiterabschnittes (10') des jeweils benachbarten Basis-Klemmenträgers (2) eingreif(t)(en).

5. Elektrisches Gerät nach einem der vorstehenden Ansprüche, **dadurch gekennzeichnet, daß** die Platine (102) in eine Öffnung (108) der Basis-Klemmenträger (2) einsetzbar ist, welche von einem Verschlußteil (114) verschließbar ist, welches mindestens eine Öffnung (116) für die mindestens zwei übereinander liegenden Anschlußreihen (106a, b) aufweist.

6. Elektrisches Gerät nach einem der vorstehenden Ansprüche, **dadurch gekennzeichnet, daß** das Verschlußteil (114) einen Führungsansatz (117) aufweist, der zum Eingriff in eine entsprechende Ausnehmung (119) der Nachbarmodulscheibe ausgelegt ist.

7. Elektrisches Gerät nach einem der vorstehenden Ansprüche, **dadurch gekennzeichnet, daß** die Anschlußreihen zur Weitergabe der Busleitersignale und/oder -versorgungsspannungen zwischen dem internen Busleiter (10) und der Elektronikleiterplatte (14) direkt den Leiterplattenrand bilden.

8. Elektrisches Gerät nach einem der vorstehenden Ansprüche, **dadurch gekennzeichnet, daß** die Anschlüsse (108) zur Weitergabe der Busleitersignale und/oder -versorgungsspannungen zwischen dem internen Busleiter (10) und der Leiterplatte (102) Kontaktflächen als Leiterbahnen am Rand der Leiterplatte (14) darstellen und über einen Leiterplattenrandverbinder auf der Elektronikleiterplatte (14) verbunden werden.

9. Elektrisches Gerät nach einem der vorstehenden Ansprüche, **dadurch gekennzeichnet, daß** die Anschlußreihen (104a, b; 106a, b; 108a, b) metallische Anschlüsse und Lichtleiteranschlüsse aufweisen.

10. Elektrisches Gerät nach einem der vorstehenden Ansprüche, **dadurch gekennzeichnet, daß** die Anschlußreihen (104a, b; 106a, b; 108a, b) Anschlüsse mit verschiedene Querschnitten aufweisen.

## Claims

1. Electrical device with modular structure for control and / or monitoring of technical processes and / or industry and / or building automation which comprises an internal bus conductor segment for forwarding bus conductor signals and / or supply voltages,
a) with at least one connection module (MS) adapted to be placed on a mounting rail with connections for external conductors, whereby each connection module comprises a disc-like base terminal carrier (2) which comprises a preferably insertable electronic module printed circuit board (14) which is adapted to be connected to an internal bus conductor (10), whereby the electronic module printed circuit board (14) is arranged substantially perpendicularly to the mounting rail, whereby - if a plurality of connecting terminals are provided - the base terminal carriers are arranged in a row,
b) whereby the internal bus conductor segments (10) of the individual base terminal carriers (2) are formed so as to be structurally separated from each other and each comprise a board (102) arranged in the base terminal carrier (2), on which at least two rows of connections (104a, b; 106a, b) lying directly on top of each other for forwarding the bus conductor signals and / or supply voltages between adjacent connection modules (M) and at least one or more rows of connections (108a, b) - in this case lying directly on top of each other - for forwarding the bus conductor signals and / or supply voltages between the internal bus conductor (10) and the electronic module printed circuit board (14) are provided,
**characterised in that**
c) the board (102) is arranged substantially parallel to the electronic module printed circuit board (14).

2. Electrical device according to claim 1, **characterised in that** the connections (14 - 108), according to conductor supply, realise a T-piece functionality with offset conductors.

3. Electrical device according to clam 1 or 2, **characterised in that** the board (102) is arranged substantially in the plane of the electronic module printed circuit board (14) in the connection module and connects directly to the electronic module printed circuit board (14).

4. Electrical device according to one of the preceding claims, **characterised in that** at least two rows of female connector strips lying on top of each other or a double-row female connector strip (110) and at least two male connector strips lying directly on top of each other or a double-row male connector strip (112) are placed on the board (102), whereby in the case of adjacently lying base terminal carriers (2) the male connector strip(s) (112) engage(s) in the female connector strip(s) (110) of the bus conductor segment (10') of the respectively adjacent base terminal carrier (2).

5. Electrical device according to one of the preceding claims, **characterised in that** the board (102) is adapted to be inserted into an opening (108) of the base terminal carriers (2) which is adapted to be closed by a closing part (114) which comprises at least one opening (116) for the at least two connection rows (106a, b) lying on top of each other.

6. Electrical device according to one of the preceding claims, **characterised in that** the closing part (114) comprises a guide attachment (117) which is designed for engagement in a corresponding recess (119) of the adjacent module disc.

7. Electrical device according to one of the preceding claims, **characterised in that** the connection rows for forwarding the bus conductor signals and / or supply voltages between the internal bus conductor (10) and the electronic module printed circuit board (14) directly form the edge of the circuit board.

8. Electrical device according to one of the preceding claims, **characterised in that** the connections (108) for forwarding the bus conductor signals and / or supply voltages between the internal bus conductor (10) and the printed circuit board (102) constitute contact surfaces as conductor paths at the edge of the circuit board (14) and are connected via a printed circuit board edge connector on the electronic module printed circuit board (14).

9. Electrical device according to one of the preceding claims, **characterised in that** the connection rows (104a, b; 106a, b; 108a, b) comprise metal connections and light guide connections.

10. Electrical device according to one of the preceding claims, **characterised in that** the connection rows (104a, b; 106a, b; 108a, b) comprise connections with different cross-sections.

## Revendications

1. Appareil électrique avec structure modulaire pour commander et/ou surveiller des processus techniques et/ou pour l'automatisation d'industries et/ou de bâtiments, comprenant une section de contact à bus interne pour transférer des signaux de bus et/ou des tensions d'alimentation,
a) avec au moins un module de raccordement (MS) applicable sur un profilé support avec des raccords pour des conducteurs externes, chaque module de raccordement comprenant un porte-borne de base (2) en forme de disque qui comporte une plaquette électronique (14) de préférence enfichable, qui est raccordable à une ligne de bus interne (10), la plaquette électronique (14) étant alignée essentiellement perpendiculairement au profilé support, les porte-bornes de base étant disposés de façon sérielle-lorsqu'une pluralité de bornes d'alimentation est prévue-,
b) les sections de contact à bus internes (10) des différents porte-bornes (2) étant configurées séparées physiquement les unes des autres, et comprennent respectivement une platine (102) disposée dans le porte-borne de base (2), sur laquelle au moins deux lignes directement superposées de raccords (104a,b ; 106a,b) sont prévues pour la transmission des signaux de bus et/ou des tensions d'alimentation entre des modules de raccordement adjacents (M), et au moins une ou plusieurs lignes de raccords (1 08a,b) -dans le présent cas directement superposées-pour la transmission des signaux de bus et/ou des tensions d'alimentation entre la ligne de bus interne (10) et la plaquette électronique (14),
**caractérisé en ce que**
c) la platine (102) est alignée essentiellement parallèlement à la plaquette électronique (14).

2. Appareil électrique selon la revendication 1, **caractérisé en ce que** les raccords (14 - 108) réalisent en fonction de l'alimentation des conducteurs une fonctionnalité de raccordement en T avec des conducteurs décalés.

3. Appareil électrique selon la revendication 1 ou 2, **caractérisé en ce que** la platine (102) est disposée essentiellement dans le plan de la plaquette électronique (14) dans le module de raccordement et est raccordée directement à la plaquette électronique (14).

4. Appareil électronique selon l'une des revendications précédentes, **caractérisé en ce que** au moins deux lignes superposées de réglettes à jacks et douilles ou une réglette à jacks et douilles double rangée (110) et au moins deux réglettes à douilles mâles directement superposées ou une réglette à douille mâle double rangée (112) sont posées sur la platine (102), la(les) réglette(s) à douille mâle (112) s'engageant dans la(les) réglette(s) à jacks et douilles (110) de la section de contact de bus (10') du porte-borne de base (2) respectivement adjacent dans le cas des porte-bornes de base (2) adjacents les uns aux autres.

5. Appareil électrique selon l'une des revendications précédentes, **caractérisé en ce que** la platine (102) peut être introduite dans une ouverture (108) du porte-borne de base (2), cette ouverture peut être fermée par une partie de fermeture (114) qui comprend au moins une ouverture (116) pour les au moins deux lignes de raccordement (106a,b) superposées.

6. Appareil électrique selon l'une des revendications précédentes, **caractérisé en ce que** la partie de fermeture (114) comprend un embout de guidage (117) qui est conçu pour l'engagement dans un évidement correspondant (119) du disque de module adjacent.

7. Appareil électrique selon l'une des revendications précédentes, **caractérisé en ce que** les lignes de raccordement pour la transmission des signaux de bus et/ou des tensions d'alimentation forment entre la ligne de bus interne (10) et la plaquette électronique (14) directement le bord de plaquette.

8. Appareil électrique selon l'une des revendications précédentes, **caractérisé en ce que** les raccordements (108) pour la transmission des signaux de bus et/ou des tensions d'alimentation entre la ligne de bus interne (10) et la plaquette (102) représentent des surfaces de contact en tant que pistes conductrices au bord de la plaquette (14), et sont reliées via un connecteur marginal de plaquette sur la plaquette électronique (14).

9. Appareil électrique selon l'une des revendications précédentes, **caractérisé en ce que** les lignes de raccordement (104a,b ;106a,b ;108a,b) comprennent des raccords métalliques et des raccords de conducteurs optiques.

10. Appareil électrique selon l'une des revendications précédentes, **caractérisé en ce que** les lignes de raccord (104a,b ;106a,b ;108a,b) comprennent des raccords de différentes sections transversales.
